# EUROPÄISCHE PATENTANMELDUNG

(11) **EP 4 571 383 A1**
(43) Veröffentlichungstag der Anmeldung: **18.06.2025**
(21) Anmeldenummer: 24218334.1
(22) Anmeldetag: 09.12.2024
(51) Int. Cl.: G02B 7/18, G03F 7/00

(54) **BAUGRUPPE FÜR EINE OPTISCHE KOMPONENTE**

(30) Priorität: 12.12.2023 DE 102023212554
(71) Anmelder: Carl Zeiss SMT GmbH, 73447 Oberkochen (DE)
(72) Erfinder: ABELE, Klaus, 73447 Oberkochen (DE); POLLOK, Fabian, 73447 Oberkochen (DE)
(74) Vertreter: Rau, Schneck & Hübner Patentanwälte Rechtsanwälte PartGmbB

(57) **Zusammenfassung**

Baugruppe für eine optische Komponente (24, 30, 35), umfassend eine optische Komponente in Form eines Spiegels (24) mit einem Komponenten-Grundkörper (25) und einer optischen Fläche (28), mindestens einem Justage-Verbindungselement (30), und einem Tragrahmen (35) mit mindestens einer Aufnahme (36), wobei das mindestens eine Justage-Verbindungselement (30) am Komponenten-Grundkörper (25) angebracht ist, und wobei der Komponenten-Grundkörper (25) über das mindestens eine Justage-Verbindungselement (30) justierbar an dem Tragrahmen (35) hängend gelagert ist, wobei das Justage-Verbindungselement (30) in die mindestens eine Aufnahme (36) des Tragrahmens (35) eingreift. Es resultiert eine Baugruppe mit verbesserter Positionierungs-Reproduzierbarkeit einer Positionierung der optischen Komponente relativ zum Tragrahmen und erleichterter Montage.

## Beschreibung

Die vorliegende Patentanmeldung nimmt die Priorität der deutschen Patentanmeldung DE 10 2023 212 554.4 in Anspruch, deren Inhalt durch Bezugnahme hierin aufgenommen wird.

Die vorliegende Erfindung betrifft eine Baugruppe für eine optische Komponente. Weiter betrifft die Erfindung ein Verfahren zum hängenden Lagern der optischen Komponente an einem Tragrahmen, eine Beleuchtungsoptik mit einer derartigen Baugruppe, ein Beleuchtungssystem mit einer derartigen Beleuchtungsoptik, ein optisches System mit einem derartigen Beleuchtungssystem und eine Projektionsbelichtungsanlage mit einem derartigen optischen System.

Ein System zur Ausrichtung eines optischen Elements ist bekannt aus der DE 10 2011 114 123 A1. Eine Baugruppe für eine mikrolithographische Projektionsbelichtungsanlage ist bekannt aus der DE 10 2018 216 934 A1.

Es ist eine Aufgabe der vorliegenden Erfindung, eine verbesserte Baugruppe für eine optische Komponente bereitzustellen, insbesondere hinsichtlich einer guten Reproduzierbarkeit einer Position der optischen Komponente relativ zum Tragrahmen und/oder einer erleichterten Montage der Baugruppe.

Diese Aufgabe wird erfindungsgemäß gelöst von einer Baugruppe für eine optische Komponente mit den in Anspruch 1 aufgeführten Merkmalen.

Die optische Komponente kann ein Spiegel sein. Alternativ kann die optische Komponente eine Linse sein. Die optische Komponente kann auch eine Mehrzahl von Spiegeln und/oder eine Mehrzahl von Linsen aufweisen. Die optische Komponente kann zum Beispiel als Facettenspiegel oder auch als MEMS-Spiegel ausgeführt sein.

Die optische Komponente kann neben dem Komponenten-Grundkörper einen Komponenten-Aufhängkörper aufweisen. Der Komponenten-Grundkörper kann insbesondere quaderförmig ausgebildet sein.

Ein quaderförmiger Komponenten-Grundkörper kann insbesondere eine quadratische Grundfläche aufweisen. Als Grundfläche sei dabei diejenige Fläche des Komponenten-Grundkörpers bezeichnet, die zur Gravitationsrichtung senkrecht steht. Die Gravitationsrichtung wird nachfolgend auch als Integrationsrichtung bezeichnet.

Der Komponenten-Grundkörper kann entlang der Gravitationsrichtung seine größte Ausdehnung aufweisen. Die Reflexionsfläche ist insbesondere eine der zur Integrationsrichtung parallel verlaufenden Seitenfläche des Komponenten-Grundkörpers.

Der Komponenten-Aufhängkörper kann insbesondere an einer der zur Integrationsrichtung senkrecht verlaufenden Fläche des Komponenten-Grundkörpers angeordnet sein. Der Komponenten-Aufhängkörper kann ebenfalls quaderförmig, insbesondere mit einer quadratischen Grundfläche, ausgebildet sein. Als Grundfläche des Komponenten-Aufhängkörpers wird ebenfalls eine der zur Gravitationsrichtung senkrecht stehenden Fläche bezeichnet.

Der Komponenten-Aufhängkörper kann senkrecht zur Gravitationsrichtung insbesondere eine größere Ausdehnung aufweisen, als der Komponenten-Grundkörper.

Die optische Komponente kann einteilig ausgebildet sein. Es ist auch möglich, dass der Komponenten-Grundkörper und der Komponenten-Aufhängkörper als zweiteiliges Set ausgebildet sind und im Nachhinein miteinander verbunden werden.

Soweit die optische Komponente als Spiegel ausgebildet ist, kann ein Komponenten-Grundkörper insbesondere, zumindest teilweise, aus Aluminium oder aus Stahl angefertigt sein. Es ist auch möglich, dass der Komponenten-Grundkörper, zumindest teilweise, aus Silizium, insbesondere siliciuminfiltriertem Siliziumcarbid angefertigt ist. Bei dem Material des Komponenten-Grundkörpers handelt es sich um ein mechanisch belastbares Material. In jedem Fall kann die Reflexionsfläche des Spiegels mit einer, im EUV-Wellenlängenbereich hochreflektiven, Schicht, die beispielsweise Molybdän oder Rubidium umfassen kann, beschichtet sein.

Der Tragrahmen kann den Komponenten-Aufhängkörper und/oder den Komponenten-Grundkörper teilweise und insbesondere vollständig umschließen. Die mindestens eine Aufnahme des Tragrahmens selbst kann ein V-förmiges Lager ausbilden, welches zur Aufnahme des nachfolgend näher erläuterten Justage-Verbindungselements dient.

Der Tragrahmen kann aus Metall, insbesondere aus Stahl, angefertigt sein. Im Allgemeinen ist der Tragrahmen aus einem mechanisch belastbaren Material angefertigt.

Das mindestens eine Justage-Verbindungselement kann insbesondere am Komponenten-Aufhängkörper befestigt sein. Es ist dafür insbesondere möglich, dass der Komponenten-Aufhängkörper über mindestens eine Komponenten-Aufnahme verfügt, in der das mindestens eine Justage-Verbindungselement befestigt sein kann.

Das Justage-Verbindungselement kann insbesondere eine Schnittstelle zur Befestigung mit dem Komponenten-Aufhängkörper aufweisen. Die Schnittstelle kann insbesondere als Flansch ausgebildet sein.

Das Justage-Verbindungselement kann insbesondere mittels Befestigungselementen wie Schrauben und/oder Bolzen kraftschlüssig am Komponenten-Aufhängkörper befestigt sein.

Das Justage-Verbindungselement kann insbesondere in das V-förmige Lager der Aufnahme des Tragrahmens eingreifen. Es ist insbesondere möglich, dass das Justage-Verbindungselement im V-förmigen Lager durch die Wirkung der Gravitation zentriert wird.

Das Justage-Verbindungselement kann eine zweite Verbindungs-Schnittstelle aufweisen, die ebenfalls als Flansch ausgebildet sein kann. Über besagte zweite Verbindungs-Schnittstelle kann das Justage-Verbindungselement in der Aufnahme des Tragrahmens befestigt werden. Zur Befestigung des Justage-Verbindungselements in der Aufnahme des Tragrahmens können insbesondere Verbindungselemente wie Schrauben und/oder Bolzen dienen.

Eine derart ausgeführte Baugruppe für eine optische Komponente ist für den Monteur deutlich leichter zusammenbaubar. Die Verbindung zwischen dem Justage-Verbindungselement und der Aufnahme ist für den Monteur deutlich zugänglicher. Hierdurch kann eine Montage effizienter und schneller durchgeführt werden.

Auch das Auseinanderbauen einer erfindungsgemäßen Baugruppe für eine optische Komponente kann deutlich effizienter und einfacher bewerkstelligt werden, da keine Justage-Verbindungselemente aus Führungsbuchsen entfernt werden müssen. Das Entfernen des Justage-Verbindungselements aus einer Führungsbuchse führt bekanntermaßen zu Partikelablagerung durch Abrasion. Diese Partikel können in der Führungsbuchse zurückbleiben und führen beim Wiederzusammenbau der Baugruppe für eine optische Komponente, beispielsweise nach Austausch der optischen Komponente zu Präzisionsverlust, was eine Positioniergenauigkeit der optischen Komponente relativ zum Tragrahmen angeht. Beim Auseinanderbauen einer erfindungsgemäßen Baugruppe muss lediglich das Justage-Verbindungselement vom Tragrahmen gelöst werden. Partikelbildung kann reduziert und insbesondere vermieden werden. Die Langlebigkeit einer erfindungsgemäßen Baugruppe kann gegenüber bekannter Baugruppen für optische Komponenten deutlich erhöht werden.

Eine Baugruppe gemäß Anspruch 2 kann mit besonders großer Präzision und insbesondere reproduzierbar zusammengebaut werden. Eine Lager-Einrichtung kann mit deutlich höherer Präzision gefertigt werden als der Tragrahmen. Durch das zusätzliche Verwenden der Lager-Einrichtung kann das Justage-Verbindungselement präziser am Tragrahmen angebracht werden. In einem solchen Fall kann die Lager-Einrichtung das V-förmige Lager ausbilden.

Eine Baugruppe gemäß Anspruch 3 dient zur besonders präzisen Ausrichtung des Justage-Verbindungselements am Tragrahmen. Durch den nach einer Seite hin offen gestalteten Querschnitt der Lager-Komponente kann ein V-förmiges Lager ausgebildet werden, in welches das Justage-Verbindungselement eingreifen kann. Die Lager-Komponente kann einen hufeneisenförmigen Querschnitt oder auch einen gabelförmigen Querschnitt aufweisen. Eine hufeisenförmige Lager-Komponente ist einfach mit großer Präzision herstellbar. Die Lager-Komponente kann dabei insbesondere aus einem Metall, insbesondere aus Stahl, angefertigt sein. Es ist auch möglich, dass die Lager-Komponente einen U-förmigen, einen V-förmigen, einen F-förmigen oder auch einen Y-förmigen Querschnitt aufweist.

Eine Baugruppe gemäß Anspruch 4 ist besonders verschleißarm. Dadurch, dass das Justage-Verbindungselement die Lager-Komponente an höchstens zwei Punkten kontaktiert, ist ein eventueller Restverschleiß, insbesondere ein Restmaterialabrieb, reduziert. Es ist insbesondere möglich, dass die zwei Kontaktpunkte an den beiden Schenkeln der hufeisenförmigen Lager-Komponente angeordnet sind. Es ist auch möglich, dass das Justage-Verbindungselement die Lager-Komponente in nur einem Punkt berührt. In einem solchen Fall kann der Berührpunkt insbesondere am Scheitel der hufeisenförmigen Lager-Komponente und insbesondere in der Nähe des Scheitels angeordnet sein.

Es ist auch möglich, dass das Justage-Verbindungselement die Lager-Komponente in höchstens zwei Linienkontakten kontaktiert. Unter einem Linienkontakt soll dabei ein dimensionaler Kontakt zwischen dem Justage-Verbindungselement und der Lager-Komponente verstanden sein. Hierfür kann die Lager-Komponente, insbesondere im Bereich der Schenkel, verjüngend ausgebildet sein. Insbesondere kann die Lager-Komponente zwei quasi-eindimensionale Schneiden von geringer Länge aufweisen, entlang derer die Lager-Komponente das Justage-Verbindungselement kontaktieren kann.

Der Linienkontakt weist insbesondere eine Länge von höchstens 2 mm, insbesondere höchstens 1,5 mm, insbesondere höchstens 1 mm und insbesondere höchstens 0,5 mm auf.

Eine Baugruppe gemäß Anspruch 5 ist besonders flexibel. Durch die Verwendung mehrerer Justage-Verbindungselemente lässt sich die optische Komponente präziser und sicherer am Tragrahmen anbringen.

Es ist dabei insbesondere möglich, dass die Baugruppe mindestens drei, insbesondere mindestens vier, insbesondere mindestens fünf und insbesondere mindestens sechs Justage-Verbindungselemente aufweist. Es ist in einem solchen Fall insbesondere möglich, dass der Tragrahmen mindestens zwei, insbesondere mindestens drei, insbesondere mindestens vier, insbesondere mindestens fünf und insbesondere mindestens sechs Aufnahmen aufweist.

Die Justage-Verbindungselemente können insbesondere asymmetrisch an der optischen Komponente, insbesondere am Komponenten-Aufhängkörper angebracht sein. Unter einer asymmetrischen Anordnung sei dabei Verstanden, dass der Massenmittelpunkt der Justage-Verbindungselemente, als gemeinsames Massensystem betrachtet, und der Massenmittelpunkt des Komponenten-Aufhängkörpers nicht auf einer, zur Gravitationsrichtung parallelen, Achse liegen.

Es ist auch möglich, dass die Justage-Verbindungselemente symmetrisch um den Massenmittelpunkt des Komponenten-Aufhängkörpers verteilt angeordnet sind. Insbesondere ist es dabei möglich, dass die Justage-Verbindungselemente eine relative Phase von 360°/n zueinander aufweisen, wobei n die Anzahl der Justage-Verbindungselemente beschreibt. Insbesondere im Fall von sechs Justage-Verbindungselementen ergibt sich eine relative Phase von 60° zueinander.

Insbesondere falls sechs Justage-Verbindungselemente verwendet werden, ist es grundsätzlich möglich diese Justage-Verbindungselemente gemäß einer sogenannten Stewart-Anordnung zu positionieren, bei der jeweils zwei Justage-Verbindungselemente zu einem Bipod zusammengefasst werden. Einzelne Bipoden können eine relative Phase von 120° zueinander aufweisen. Eine Stewart-Anordnung, in Form einer Stewart-Platform ist in der DE 10 2011 114 123 A1 näher beschrieben.

Unter einer relativen Phase sei dabei derjenige Winkel verstanden, der entsteht, wenn die jeweiligen Massenmittelpunkte des Komponenten-Aufhängkörpers und zweier Justage-Verbindungselemente oder Bipoden in eine zur Gravitation senkrechte Ebene projiziert werden und besagte Projektionspunkte zu einem gleichschenkligen Dreieck verbunden werden wobei der Winkel keiner der Basiswinkel des gleichschenkligen Dreiecks ist.

Eine Baugruppe gemäß Anspruch 6 ist besonders sicher und langlebig. Dadurch, dass jedes der Justage-Verbindungselemente mit einer von Null verschiedenen Zugkraft belastet wird, teilt sich die Gewichtskraft der optischen Komponente auf alle Justage-Verbindungselemente auf. Dadurch wird eine einseitige Belastung eines der Justage-Verbindungselemente vermieden. Eine asymmetrische Abnutzung verschiedener Justage-Verbindungselemente wird reduziert und insbesondere vermieden.

Es ist dabei insbesondere möglich, dass die Gewichtskraft der optischen Komponente gleichmäßig auf alle Justage-Verbindungselemente verteilt wird. Es ist auch möglich, dass jedes der Justage-Verbindungselemente einen anderen Teil der Gewichtskraft aufnimmt.

Es ist insbesondere möglich, dass jedes der Justage-Verbindungselemente mit einer Zugkraft belastet wird, die insbesondere größer ist als 20 N, insbesondere größer als 40 N, insbesondere größer als 80 N und insbesondere größer als 100 N. Ein einzelnes Justage-Verbindungselement wird mit einer Zugkraft belastet, die insbesondere kleiner ist als 3.000 N und beispielsweise im Bereich zwischen 1.000 N und 3.000 N liegen kann.

Eine Baugruppe gemäß Anspruch 7 ist besonders einfach justierbar. Der stabförmig ausgebildete Verbindungs-Grundkörper kann insbesondere zylinderförmig ausgebildet sein. Der Verbindungs-Grundkörper kann insbesondere eine Symmetrieachse aufweisen. Die Zugkraft, mit der ein Justage-Verbindungselement belastet wird, kann auf das Justage-Verbindungselement dann insbesondere entlang der Symmetrieachse des Verbindungs-Grundkörpers wirken. Dadurch, dass in einem solchen Fall keine Momente auftreten, kann ein entsprechendes Justage-Verbindungselement darüber hinaus besonders sicher verwendet werden.

Eine Baugruppe gemäß Anspruch 8 ist besonders flexibel einsetzbar. Durch das mindestens eine Festkörpergelenk erhält das Justage-Verbindungselement darüber hinaus elastische Eigenschaften. Dies erleichtert den Zusammenbau der Baugruppe erheblich.

Der Verbindungs-Grundkörper kann dabei insbesondere mindestens zwei, insbesondere mindestens drei und insbesondere mindestens vier Festkörpergelenke umfassen. Hierdurch kann das Justage-Verbindungselement entlang mindestens eines Rotationsfreiheitsgrades und mindestens eines Translationsfreiheitsgrades bewegt werden.

Es ist insbesondere möglich, dass das Justage-Verbindungselement entlang mindestens zwei, insbesondere mindestens drei Translationsfreiheitsgraden und/oder Rotationsfreiheitsgraden verstellt werden kann. Dies ermöglicht insbesondere eine Bewegung der optischen Komponente um mindestens einen, insbesondere mindestens zwei und insbesondere mindestens drei Rotations- und/oder Translationsfreiheitsgraden. Eine derartig einstellbare optische Komponente ist besonders geeignet für den Einsatz in EUV-Projektionsbelichtungsanlagen.

Eine Baugruppe gemäß Anspruch 9 erhöht die Präzision der Baugruppe und durch den Einsatz zusätzlicher Justage-Distanzelemente kann die Länge einzelner Justage-Verbindungselemente vergrößert werden. Hierdurch kann die Ausrichtung der optischen Komponente zum Tragrahmen zielgenau beeinflusst werden.

Die Justage-Distanzelemente können insbesondere als Distanz-Scheiben unterschiedlicher Dicke ausgebildet sein, die zwischen das Justage-Distanzelement und der Aufnahme des Tragrahmens, oder zwischen das Justage-Distanzelement und der Lage-Einrichtung positioniert werden können.

Es ist eine weitere Aufgabe der vorliegenden Erfindung, ein Verfahren zum hängenden Lagern einer optischen Komponente an einem Tragrahmen zu verbessern.

Diese Aufgabe wird gelöst durch ein Verfahren mit den in Anspruch 10 aufgeführten Merkmalen. Die Vorteile eines solchen Verfahrens entsprechen denen, die unter Bezugnahme auf die Baugruppe bereits erläutert worden sind.

Insbesondere, falls die optische Komponente mit einer Mehrzahl von Justage-Verbindungseinrichtungen an einem Tragrahmen mit einer Mehrzahl von Aufnahmen angebracht werden soll, kann nicht jede der Justage-Verbindungseinrichtungen gleichzeitig in der zugehörigen Aufnahme des Tragrahmens angeordnet werden. In einem solchen Fall wird zunächst das erste Justage-Verbindungselement in die erste Aufnahme des Tragkörpers eingebracht. Durch ein Absenken der optischen Komponente wird besagtes erste Justage-Verbindungselement in seiner Aufnahme zentriert. Dieser Schritt ist dann sukzessive für die weiteren Justage-Verbindungselemente und deren zugehörige Aufnahmen zu wiederholen.

Insbesondere falls zur Lagerung der optischen Komponente am Tragrahmen eine Lager-Einrichtung verwendet werden soll, kann besagte Lager-Einrichtung in einem weiteren Verfahrensschritt an dem Tragrahmen, insbesondere in der Aufnahme des Tragrahmens, befestigt werden. Insbesondere kann die Lager-Einrichtung derart in der Aufnahme des Tragrahmens befestigt werden, dass die Lager-Einrichtung zwischen dem Tragrahmen und dem Justage-Verbindungselement angeordnet ist.

Insbesondere falls das Justage-Verbindungselement einen stabförmigen Grundkörper aufweisen, der mindestens ein Festkörpergelenk umfasst, kann dieses Verfahren besonders einfach durchgeführt werden, da die Bewegung der optischen Komponente durch die Elastizität der Justage-Verbindungselemente erleichtert wird, insbesondere dann, wenn bei einer Verwendung mehrerer Justage-Verbindungselemente schon mindestens ein Justage-Verbindungselement in seiner Aufnahme zentriert angeordnet ist. Durch die Elastizität der Justage-Verbindungselemente kann die optische Komponente, bei der es sich um einen Spiegel handeln kann, dann einfacher bewegt werden, bis sich die übrigen Justage-Verbi<ndungselemente in ihren jeweiligen Aufnahmen finden. Die Gefahr, dass Justage-Verbindungselemente, die bereits in ihrer Aufnahme angeordnet sind dabei verbogen werden und/oder brechen, kann reduziert und insbesondere vermieden werden.

Weitere Aufgaben der Erfindung sind das Verbessern einer Beleuchtungsoptik, eines Beleuchtungssystems, eines optischen Systems und einer Projektionsbelichtungsanlage.

Diese Aufgaben werden gelöst durch eine Beleuchtungsoptik mit den in Anspruch 11 aufgeführten Merkmalen, ein Beleuchtungssystem mit den in Anspruch 12 aufgeführten Merkmalen, ein optisches System mit den in Anspruch 13 aufgeführten Merkmalen und eine Projektionsbelichtungsanlage mit den in Anspruch 14 aufgeführten Merkmalen.

Eventuelle Vorteile dieser übergeordneten Systeme entsprechen denen, die unter Bezugnahme auf die Baugruppe bereits erläutert worden sind.

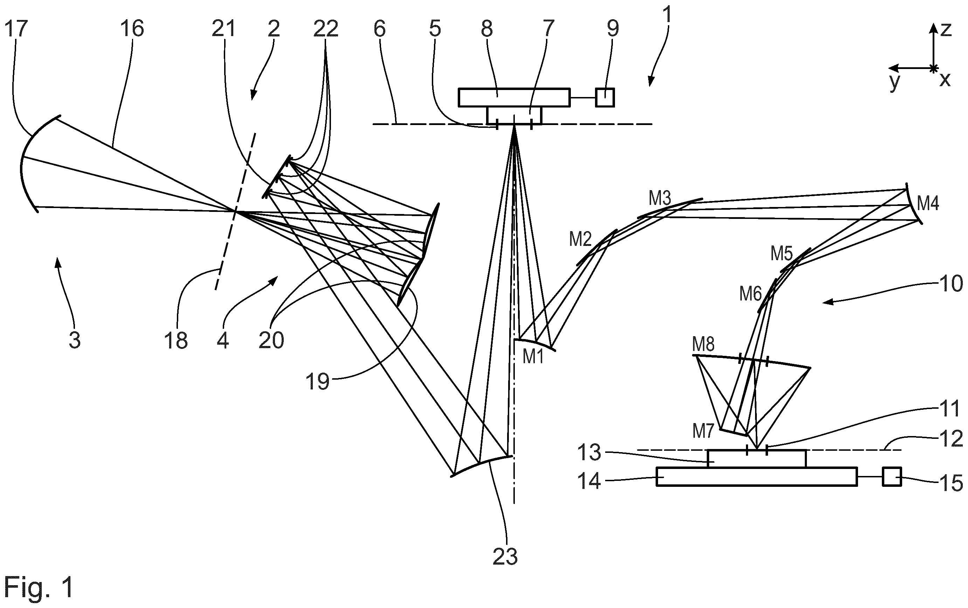

Nachfolgend wird anhand der Zeichnung mindestens ein Ausführungsbeispiel der Erfindung beschrieben. In der Zeichnung zeigen:
- Fig. 1: schematisch im Meridionalschnitt eine Projektionsbelichtungsanlage für die EUV-Projektionslithografie;
- Fig. 2: eine schematische Ansicht einer optischen Komponente der Projektionsbelichtungsanlage in Form eines Spiegels mit sechs Justage-Verbindungselementen;
- Fig. 3: in Draufsicht den Spiegel, die sechs Justage-Verbindungselemente und den Tragrahmen;
- Fig. 4: in gebrochener Schnittdarstellung die Lagerung des Spiegels im Tragrahmen mittels eines der Justage-Verbindungselemente;
- Fig. 5: in vergrößerter schematischer Ansicht einen Abschnitt des Justage-Verbindungselements und dessen Lagerung in der Lager-Einrichtung;
- Fig. 6: in einer Seitenansicht das Justage-Verbindungselement; und
- Fig. 7: in vergrößerter Ansicht die Verbindungs-Komponente in einer perspektivischen Ansicht.
Im Folgenden werden zunächst unter Bezugnahme auf die Figur 1 exemplarisch die wesentlichen Bestandteile einer Projektionsbelichtungsanlage 1 für die Mikrolithographie beschrieben. Die Beschreibung des grundsätzlichen Aufbaus der Projektionsbelichtungsanlage 1 sowie deren Bestandteile sei hierbei nicht einschränkend verstanden.

Eine Ausführung eines Beleuchtungssystems 2 der Projektionsbelichtungsanlage 1 hat neben einer Licht- bzw. Strahlungsquelle 3 eine Beleuchtungsoptik 4 zur Beleuchtung eines Objektfeldes 5 in einer Objektebene 6. Bei einer alternativen Ausführung kann die Lichtquelle 3 auch als ein zum sonstigen Beleuchtungssystem separates Modul bereitgestellt sein. In diesem Fall umfasst das Beleuchtungssystem die Lichtquelle 3 nicht.

Belichtet wird ein im Objektfeld 5 angeordnetes Retikel 7. Das Retikel 7 ist von einem Retikelhalter 8 gehalten. Der Retikelhalter 8 ist über einen Retikelverlagerungsantrieb 9 insbesondere in einer Scanrichtung verlagerbar.

In der Figur 1 ist zur Erläuterung ein kartesisches xyz-Koordinatensystem eingezeichnet. Die x-Richtung verläuft senkrecht zur Zeichenebene hinein. Die y-Richtung verläuft horizontal und die z-Richtung verläuft vertikal. Die Scanrichtung verläuft in der Figur 1 längs der y-Richtung. Die z-Richtung verläuft senkrecht zur Objektebene 6.

Die Projektionsbelichtungsanlage 1 umfasst eine Projektionsoptik 10. Die Projektionsoptik 10 dient zur Abbildung des Objektfeldes 5 in ein Bildfeld 11 in einer Bildebene 12. Die Bildebene 12 verläuft parallel zur Objektebene 6. Alternativ ist auch ein von 0° verschiedener Winkel zwischen der Objektebene 6 und der Bildebene 12 möglich.

Abgebildet wird eine Struktur auf dem Retikel 7 auf eine lichtempfindliche Schicht eines im Bereich des Bildfeldes 11 in der Bildebene 12 angeordneten Wafers 13. Der Wafer 13 wird von einem Waferhalter 14 gehalten. Der Waferhalter 14 ist über einen Waferverlagerungsantrieb 15 insbesondere längs der y-Richtung verlagerbar. Die Verlagerung einerseits des Retikels 7 über den Retikelverlagerungsantrieb 9 und andererseits des Wafers 13 über den Waferverlagerungsantrieb 15 kann synchronisiert zueinander erfolgen.

Bei der Strahlungsquelle 3 handelt es sich um eine EUV-Strahlungsquelle. Die Strahlungsquelle 3 emittiert insbesondere EUV-Strahlung 16, welche im Folgenden auch als Nutzstrahlung oder Beleuchtungsstrahlung bezeichnet wird. Die Nutzstrahlung hat insbesondere eine Wellenlänge im Bereich zwischen 5 nm und 30 nm. Bei der Strahlungsquelle 3 kann es sich um eine Plasmaquelle handeln, zum Beispiel um eine LPP-Quelle (Laser Produced Plasma, mithilfe eines Lasers erzeugtes Plasma) oder um eine DPP-Quelle (Gas Discharged Produced Plasma, mittels Gasentladung erzeugtes Plasma). Es kann sich auch um eine synchrotronbasierte Strahlungsquelle handeln. Bei der Strahlungsquelle 3 kann es sich um einen Freie-Elektronen-Laser (Free-Electron-Laser, FEL) handeln. Die Strahlungsquelle 3 kann eine zinnbasierte oder xenonbasierte EUV-Strahlungsquelle sein. Je nach Ausführung der Projektionsbelichtungsanlage 1 kann es sich bei der Strahlungsquelle 3 auch um eine DUV-Strahlungsquelle mit einer Nutzwellenlänge für die Strahlung 16 im Bereich beispielsweise zwischen 193 nm und 365 nm handeln.

Die Beleuchtungsstrahlung 16, die von der Strahlungsquelle 3 ausgeht, wird von einem Kollektor 17 gebündelt. Bei dem Kollektor 17 kann es sich um einen Kollektor mit einer oder mit mehreren ellipsoidalen und/oder hyperboloiden Reflexionsflächen handeln. Die mindestens eine Reflexionsfläche des Kollektors 17 kann im streifenden Einfall (Grazing Incidence, GI), also mit Einfallswinkeln größer als 45°, oder im normalen Einfall (Normal Incidence, NI), also mit Einfallwinkeln kleiner als 45°, mit der Beleuchtungsstrahlung 16 beaufschlagt werden. Der Kollektor 17 kann einerseits zur Optimierung seiner Reflektivität für die Nutzstrahlung und andererseits zur Unterdrückung von Falschlicht strukturiert und/oder beschichtet sein.

Nach dem Kollektor 17 propagiert die Beleuchtungsstrahlung 16 durch einen Zwischenfokus in einer Zwischenfokusebene 18. Die Zwischenfokusebene 18 kann eine Trennung zwischen einem Strahlungsquellenmodul, aufweisend die Strahlungsquelle 3 und den Kollektor 17, und der Beleuchtungsoptik 4 darstellen.

Die Beleuchtungsoptik 4 umfasst einen ersten Facettenspiegel 19. Sofern der erste Facettenspiegel 19 in einer Ebene der Beleuchtungsoptik 4 angeordnet ist, die zur Objektebene 6 optisch konjugiert ist, wird dieser auch als Feldfacettenspiegel bezeichnet. Der erste Facettenspiegel 19 umfasst eine Vielzahl von einzelnen ersten Facetten 20, welche im Folgenden auch als Feldfacetten bezeichnet werden. Von diesen Facetten sind in der Figur 1 nur beispielhaft einige dargestellt.

Die ersten Facetten 20 können als makroskopische Facetten ausgeführt sein, insbesondere als rechteckige Facetten oder als Facetten mit bogenförmiger oder teilkreisförmiger Randkontur. Die ersten Facetten 20 können als plane Facetten oder alternativ als konvex oder konkav gekrümmte Facetten ausgeführt sein.

Wie beispielsweise aus der DE 10 2008 009 600 A1 bekannt ist, können die ersten Facetten 20 selbst jeweils auch aus einer Vielzahl von Einzelspiegeln, insbesondere einer Vielzahl von Mikrospiegeln, zusammengesetzt sein. Der erste Facettenspiegel 19 kann insbesondere als mikroelektromechanisches System (MEMS-System) ausgebildet sein. Für Details wird auf die DE 10 2008 009 600 A1 verwiesen.

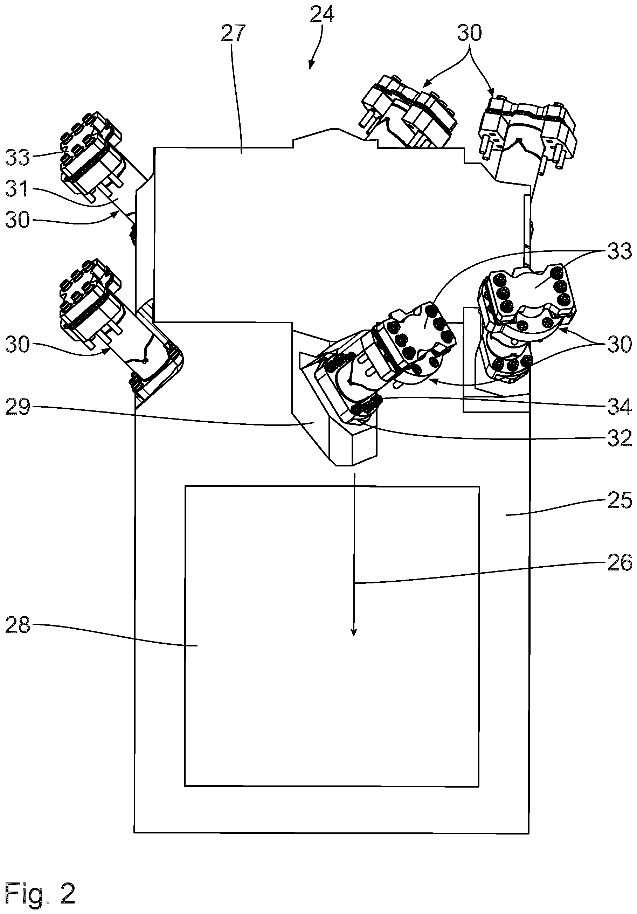

Insbesondere der erste Facettenspiegel 19 ist hängend an einem Tragrahmen gelagert. Die genaue Ausgestaltung der hängenden Lagerung und die damit einhergehenden Komponenten werden nachfolgend unter Bezugnahme auf die Fig. 2 bis 7 näher erläutert.

Im Strahlengang der Beleuchtungsoptik 4 ist dem ersten Facettenspiegel 19 nachgeordnet ein zweiter Facettenspiegel 21. Sofern der zweite Facettenspiegel 21 in einer Pupillenebene der Beleuchtungsoptik 4 angeordnet ist, wird dieser auch als Pupillenfacettenspiegel bezeichnet. Der zweite Facettenspiegel 21 kann auch beabstandet zu einer Pupillenebene der Beleuchtungsoptik 4 angeordnet sein. In diesem Fall wird die Kombination aus dem ersten Facettenspiegel 19 und dem zweiten Facettenspiegel 21 auch als spekularer Reflektor bezeichnet. Spekulare Reflektoren sind bekannt aus der US 2006/0132747 A1, der EP 1 614 008 B1 und der US 6,573,978.

Der zweite Facettenspiegel 21 umfasst eine Mehrzahl von zweiten Facetten 22. Die zweiten Facetten 22 werden im Falle eines Pupillenfacettenspiegels auch als Pupillenfacetten bezeichnet.

Bei den zweiten Facetten 22 kann es sich ebenfalls um makroskopische Facetten, die beispielsweise rund, rechteckig oder auch hexagonal berandet sein können, oder alternativ um aus Mikrospiegeln zusammengesetzte Facetten handeln. Diesbezüglich wird ebenfalls auf die DE 10 2008 009 600 A1 verwiesen.

Die zweiten Facetten 22 können plane oder alternativ konvex oder konkav gekrümmte Reflexionsflächen aufweisen.

Die Beleuchtungsoptik 4 bildet somit ein doppelt facettiertes System. Dieses grundlegende Prinzip wird auch als Wabenkondensor (Fly's Eye Integrator) bezeichnet.

Es kann vorteilhaft sein, den zweiten Facettenspiegel 21 nicht exakt in einer Ebene, welche zu einer Pupillenebene der Projektionsoptik 10 optisch konjugiert ist, anzuordnen. Insbesondere kann der Pupillenfacettenspiegel 22 gegenüber einer Pupillenebene der Projektionsoptik 10 verkippt angeordnet sein, wie es zum Beispiel in der DE 10 2017 220 586 A1 beschrieben ist.

Mit Hilfe des zweiten Facettenspiegels 21 und einer abbildenden optischen Baugruppe in Form einer Übertragungsoptik 23 werden die einzelnen ersten Facetten 20 in das Objektfeld 5 abgebildet.

Die Übertragungsoptik 23 kann genau einen Spiegel, alternativ aber auch zwei oder mehr Spiegel aufweisen, welche hintereinander im Strahlengang der Beleuchtungsoptik 4 angeordnet sind. Die Übertragungsoptik kann insbesondere einen oder zwei Spiegel für senkrechten Einfall (NI-Spiegel, Normal Incidence Spiegel) und/oder einen oder zwei Spiegel für streifenden Einfall (GI-Spiegel, Gracing Incidence Spiegel) umfassen. Die Beleuchtungsoptik 4 hat bei der Ausführung, die in der Figur 1 gezeigt ist, also nach dem Kollektor 17 genau drei Spiegel, nämlich die Übertragungsoptik 23, den ersten Facettenspiegel 19 und den Pupillenfacettenspiegel 21.

Soweit die Übertragungsoptik 23 nach dem zweiten Facettenspiegel 21 entfällt, ist der zweite Facettenspiegel 21 der letzte bündelformende oder auch tatsächlich der letzte Spiegel für die Beleuchtungsstrahlung 16 im Strahlengang vor dem Objektfeld 5. Ein Beispiel für eine Beleuchtungsoptik 4 ohne Übertragungsoptik ist offenbart in der Figur 2 der WO 2019/096654 A1.

Die Abbildung der ersten Facetten 20 mittels der zweiten Facetten 22 beziehungsweise mit den zweiten Facetten 22 und einer Übertragungsoptik 23 in die Objektebene 6 ist regelmäßig nur eine näherungsweise Abbildung.

Die Projektionsoptik 10 umfasst eine Mehrzahl von Spiegeln Mi, welche gemäß ihrer Anordnung im Strahlengang der Projektionsbelichtungsanlage 1 durchnummeriert sind.

Bei dem in der Figur 1 dargestellten Beispiel umfasst die Projektionsoptik 10 acht Spiegel M1 bis M8. Alternativen mit vier, sechs, zehn, zwölf oder einer anderen Anzahl an Spiegeln Mi sind ebenso möglich. Bei der Projektionsoptik 10 handelt es sich um eine obskurierte Optik. Der letzte Spiegel M8 hat eine Durchtrittsöffnung für die Beleuchtungsstrahlung 16. Die Projektionsoptik 10 hat eine bildseitige numerische Apertur, die größer ist als 0,4 und die beispielsweise 0,5 betragen kann. Die bildseitige numerische Apertur kann auch noch größer sein, kann größer sein als 0,6 und kann zum Beispiel 0,7 oder 0,75 betragen.

Reflexionsflächen der Spiegel Mi können als Freiformflächen ohne Rotationssymmetrieachse ausgeführt sein. Alternativ können die Reflexionsflächen der Spiegel Mi als asphärische Flächen mit genau einer Rotationssymmetrieachse der Reflexionsflächenform gestaltet sein. Die Spiegel Mi können, genauso wie die Spiegel der Beleuchtungsoptik 4, hoch reflektierende Beschichtungen für die Beleuchtungsstrahlung 16 aufweisen. Diese Beschichtungen können als Multilayer-Beschichtungen, insbesondere mit alternierenden Lagen aus Molybdän und Silizium, gestaltet sein.

Die Projektionsoptik 10 kann insbesondere anamorphotisch ausgebildet sein. Sie weist insbesondere unterschiedliche Abbildungsmaßstäbe βₓ, β_{y} in x- und y-Richtung auf. Die beiden Abbildungsmaßstäbe βₓ, β_{y} der Projektionsoptik 10 liegen bevorzugt bei (βₓ, β_{y}) = (+/- 0,25, +/- 0,125). Ein positiver Abbildungsmaßstab β bedeutet eine Abbildung ohne Bildumkehr. Ein negatives Vorzeichen für den Abbildungsmaßstab β bedeutet eine Abbildung mit Bildumkehr.

Die Projektionsoptik 10 führt in x-Richtung, das heißt in Richtung senkrecht zur Scanrichtung, zu einer Verkleinerung im Verhältnis 4:1.

Die Projektionsoptik 10 führt in y-Richtung, das heißt in Scanrichtung, zu einer Verkleinerung von 8:1.

Andere Abbildungsmaßstäbe sind ebenso möglich. Auch vorzeichengleiche und absolut gleiche Abbildungsmaßstäbe in x- und y-Richtung, zum Beispiel mit Absolutwerten von 0,125 oder 0,25, sind möglich.

Die Anzahl von Zwischenbildebenen in der x- und in der y-Richtung im Strahlengang zwischen dem Objektfeld 5 und dem Bildfeld 11 kann gleich sein oder kann, je nach Ausführung der Projektionsoptik 10, unterschiedlich sein. Beispiele für Projektionsoptiken mit unterschiedlichen Anzahlen derartiger Zwischenbilder in x- und y-Richtung sind bekannt aus der US 2018/0074303 A1.

Jeweils eine der Pupillenfacetten 22 ist genau einer der Feldfacetten 20 zur Ausbildung jeweils eines Beleuchtungskanals zur Ausleuchtung des Objektfeldes 5 zugeordnet. Es kann sich hierdurch insbesondere eine Beleuchtung nach dem Köhlerschen Prinzip ergeben. Das Fernfeld wird mit Hilfe der Feldfacetten 20 in eine Vielzahl an Objektfeldern 5 zerlegt. Die Feldfacetten 20 erzeugen eine Mehrzahl von Bildern des Zwischenfokus auf den diesen jeweils zugeordneten Pupillenfacetten 22.

Die Feldfacetten 20 werden jeweils von einer zugeordneten Pupillenfacette 22 einander überlagernd zur Ausleuchtung des Objektfeldes 5 auf das Retikel 7 abgebildet. Die Ausleuchtung des Objektfeldes 5 ist insbesondere möglichst homogen. Sie weist vorzugsweise einen Uniformitätsfehler von weniger als 2 % auf. Die Felduniformität kann über die Überlagerung unterschiedlicher Beleuchtungskanäle erreicht werden.

Durch eine Anordnung der Pupillenfacetten kann geometrisch die Ausleuchtung der Eintrittspupille der Projektionsoptik 10 definiert werden. Durch Auswahl der Beleuchtungskanäle, insbesondere der Teilmenge der Pupillenfacetten, die Licht führen, kann die Intensitätsverteilung in der Eintrittspupille der Projektionsoptik 10 eingestellt werden. Diese Intensitätsverteilung wird auch als Beleuchtungssetting oder Beleuchtungspupillenfüllung fly bezeichnet.

Eine ebenfalls bevorzugte Pupillenuniformität im Bereich definiert ausgeleuchteter Abschnitte einer Beleuchtungspupille der Beleuchtungsoptik 4 kann durch eine Umverteilung der Beleuchtungskanäle erreicht werden.

Im Folgenden werden weitere Aspekte und Details der Ausleuchtung des Objektfeldes 5 sowie insbesondere der Eintrittspupille der Projektionsoptik 10 beschrieben.

Die Projektionsoptik 10 kann insbesondere eine homozentrische Eintrittspupille aufweisen. Diese kann zugänglich sein. Sie kann auch unzugänglich sein.

Die Eintrittspupille der Projektionsoptik 10 lässt sich regelmäßig mit dem Pupillenfacettenspiegel 21 nicht exakt ausleuchten. Bei einer Abbildung der Projektionsoptik 10, welche das Zentrum des Pupillenfacettenspiegels 21 telezentrisch auf den Wafer 13 abbildet, schneiden sich die Aperturstrahlen oftmals nicht in einem einzigen Punkt. Es lässt sich jedoch eine Fläche finden, in welcher der paarweise bestimmte Abstand der Aperturstrahlen minimal wird. Diese Fläche stellt die Eintrittspupille oder eine zu ihr konjugierte Fläche im Ortsraum dar. Insbesondere zeigt diese Fläche eine endliche Krümmung.

Es kann sein, dass die Projektionsoptik 10 unterschiedliche Lagen der Eintrittspupille für den tangentialen und für den sagittalen Strahlengang aufweist. In diesem Fall sollte ein abbildendes Element, insbesondere ein optisches Bauelement der Übertragungsoptik 23, zwischen dem zweiten Facettenspiegel 21 und dem Retikel 7 bereitgestellt werden. Mit Hilfe dieses optischen Elements kann die unterschiedliche Lage der tangentialen Eintrittspupille und der sagittalen Eintrittspupille berücksichtigt werden.

Bei der in der Figur 1 dargestellten Anordnung der Komponenten der Beleuchtungsoptik 4 ist der Pupillenfacettenspiegel 21 nicht in einer zur Eintrittspupille der Projektionsoptik 10 konjugierten Fläche angeordnet. Er ist außerdem verkippt zur Objektebene 5 angeordnet. Der zweite Facettenspiegel 21 ist weiterhin verkippt zu einer Anordnungsebene angeordnet, die vom ersten Facettenspiegel 19 definiert ist.

Mit Hilfe der Projektionsbelichtungsanlage 1 wird wenigstens ein Teil des Retikels 7 im Objektfeld 5 auf einen Bereich einer lichtempfindlichen Schicht auf dem Wafer 13 im Bildfeld 11 zur lithographischen Herstellung eines mikro- bzw. nanostrukturierten Bauteils, insbesondere eines Halbleiterbauteils, beispielsweise eines Mikrochips, abgebildet. Je nach Ausführung der Projektionsbelichtungsanlage 1 als Scanner oder als Stepper werden das Retikel 7 und der Wafer 13 zeitlich synchronisiert in der y-Richtung kontinuierlich im Scannerbetrieb oder schrittweise im Stepperbetrieb verfahren.

Je nach Ausführung können einzelne Komponenten oder Komponenten-Baugruppen, die vorstehend beschrieben wurden, beispielsweise der EUV-Kollektor 17, die Beleuchtungsoptik 4 oder die Projektionsoptik 10 auch Komponenten einer Masken-Inspektionsvorrichtung bzw. einer Masken-Metrologievorrichtung sein. Grundsätzlich bekannt ist ein Maskeninspektionssystem aus der US 10,042,248 B2, der DE 102 20 815 A1 und aus der WO 2012/101 269 A1.

Die Projektionsoptik bzw. Abbildungsoptik einer solchen Masken-Inspektionsvorrichtung bzw. Masken-Metrologievorrichtung kann so ausgeführt sein, dass eine vergrößernde Projektion bzw. Abbildung vom Objektfeld 5 in das Bildfeld 11 erfolgt.

Fig. 2 zeigt einen Spiegel 24 in schematischer Ansicht. Bei dem Spiegel 24 handelt es sich um eine der optischen Komponenten zur Führung der EUV-Strahlung 16, beispielsweise um den ersten Facettenspiegel 19, um den zweiten Facettenspiegel 21, um einen Spiegel der Übertragungsoptik 23 oder auch um einen Spiegel Mi der Projektionsoptik 10. Grundsätzlich kann anstelle des Spiegels 24 auch eine Linse, beispielsweise bei Verwendung einer DUV-Projektionsbelichtungsanlage, zum Einsatz kommen.

Der Spiegel 24 umfasst einen Komponenten-Grundkörper in Form eines Spiegel-Grundkörpers 25, der seine größte Ausdehnung entlang der Gravitationsrichtung 26 aufweist. Der Spiegel 24 umfasst weiterhin einen Komponenten-Aufhängkörper in Form eines Spiegel-Aufhängkörpers 27, der am, in Gravitationsrichtung 26 betrachtet, oberen Ende des Spiegel-Grundkörpers 25 angeordnet ist. Der Spiegel-Aufhängkörper 27 hat in der zur Gravitationsrichtung 26 senkrechten Ebene eine größere Ausdehnung als der Spiegel-Grundkörper 25.

Der Spiegel 24 weist eine optische Fläche in Form einer Reflexionsfläche 28 auf. Die Reflexionsfläche 28 ist an einer der zur Gravitationsrichtung 26 parallelen Seitenfläche des Spiegel-Grundkörpers 25 angeordnet.

Der Spiegel-Aufhängkörper 27 weist sechs Komponenten-Aufnahmen in Form von Spiegel-Aufnahmen 29 auf. Die Spiegel-Aufnahmen 29 sind nach oben hin offen, um jeweils ein Justage-Verbindungselement 30 aufzunehmen.

Das Justage-Verbindungselement 30 weist einen zylinderförmigen, länglichen Verbindungselement-Grundkörper 31 auf. Der Verbindungselement-Grundkörper 31 weist an seinem einen Ende einen Komponenten-Flansch in Form eines Spiegel-Flansches 32 auf, mit dem das Justage-Verbindungselement 30 an dem Spiegel 24 befestigt ist.

Der Verbindungselement-Grundkörper 31 weist an seinem anderen Ende einen Tragrahmen-Flansch 33 auf. Mit dem Tragrahmen-Flansch 33 ist das Justage-Verbindungselement 30 an dem, nicht in der Fig. 1 dargestellten, Tragrahmen befestigbar. Spiegel-Flansch 32 und Tragrahmen-Flansch 33 sind senkrecht zueinander orientiert.

Die Justage-Verbindungselemente 30 sind in ihrer jeweiligen Spiegel-Aufnahmen 29 mittels mindestens eines Komponenten-Befestigungselements in Form eines Spiegel-Befestigungselements 34 befestigt. Bei dem Spiegel-Befestigungselement 34 kann es sich um Schrauben oder Bolzen handeln. Jedes Justage-Verbindungselement 30 ist dabei mit sechs Spiegel-Befestigungselementen 34 in der jeweiligen Spiegel-Aufnahme 29 des Spiegel-Aufhängkörpers 27 befestigt.

Zur Aufnahme der Spiegel-Befestigungselemente 34 weist der jeweilige Spiegel-Flansch 32 sechs Durchgangsöffnungen auf, über die die Spiegel-Befestigungselemente 34 den Spiegel-Flansch 32 und damit das Justage-Verbindungselement 30 kraftschlüssig am Spiegel-Aufhängkörper 27 befestigen.

Die Justage-Verbindungselemente 30 sind im, in der Fig. 2 gezeigten, Ausführungsbeispiel entlang der Mantelfläche des Spiegel-Aufhängkörpers 27 angeordnet. Die Mantelfläche des Spiegel-Aufhängkörpers 27 wird insbesondere aus den vier zur Gravitationsrichtung 26 parallelen Seitenflächen des Spiegel-Aufhängkörpers 27 gebildet. Die Verteilung der Justage-Verbindungselemente 30 ist dabei asymmetrisch. Oberhalb der Reflexionsfläche 28 sind zwei der sechs Justage-Verbindungselemente angeordnet, während oberhalb der, der Reflexionsfläche gegenüberliegenden Seitenfläche, vier Justage-Verbindungselemente 30 angeordnet sind. Es resultiert eine Hexapoden-Anordnung der Justage-Verbindungselemente 30.

Generell ist auch eine symmetrische Anordnung der Justage-Verbindungselemente 30 möglich. Insbesondere können die Justage-Verbindungselemente 30 entlang der Mantelfläche des Spiegel-Aufhängkörpers 27 gleich verteilt, also mit einer relativen Phase von 60° zueinander angeordnet sein. Es ist auch möglich, dass jeweils zwei Justage-Verbindungselemente 30 einen Bipod ausbilden. Die daraus resultierenden drei Bipoden von Justage-Verbindungselementen 30 können insbesondere gemäß einer Stewart-Anordnung, also mit einer relativen Phase von 120° zueinander angeordnet sein.

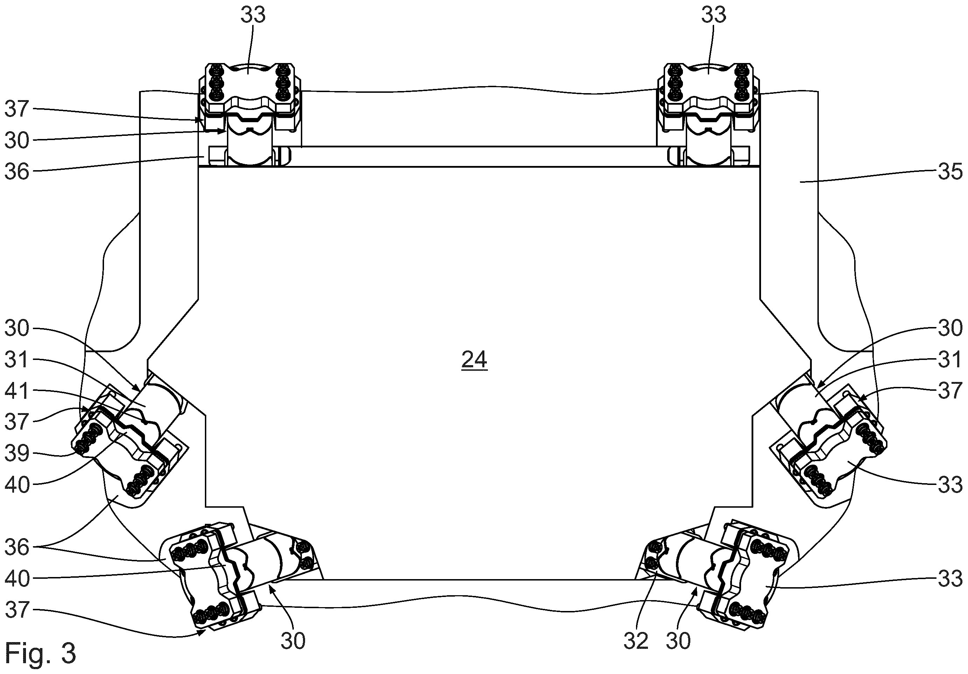

Fig. 3 zeigt den Spiegel 24 und den Tragrahmen 35 in Draufsicht. Der Tragrahmen 35 umschließt den Spiegel-Aufhängkörper 27 vollständig.

Der Tragrahmen 35 weist im in der Fig. 3 gezeigten Ausführungsbeispiel sechs Aufnahmen 36 auf. Die Aufnahmen 36 dienen der Lagerung der jeweiligen Tragrahmen-Flansche 33 der Justage-Verbindungselemente 30. Die Aufnahmen 36 sind dabei als V-förmige Vertiefungen in den Tragrahmen 35 eingebracht, sodass der Verbindungsgrundkörper 31 der Justage-Verbindungselemente 30 in der V-förmigen Aufnahme 36 zentriert angeordnet ist.

Das jeweilige Justage-Verbindungselement 30 ist mittels des jeweiligen Tragrahmen-Flansches 33 in der jeweiligen Aufnahme 36 in zentrierter Position befestigt. Zur Befestigung der jeweiligen Justage-Verbindungselemente 30 am Tragrahmen 35 sind im in der Fig. 3 gezeigten Ausführungsbeispiel zusätzliche Lager-Einrichtungen 37 zwischen dem Tragrahmen-Flansch 33 und der Aufnahme 36 des Tragrahmens 35 angeordnet.

Die Lager-Einrichtung 37 umfasst dabei eine Lager-Komponente 38. Die Lager-Komponente 38 ist hufeisenförmig ausgeführt und umfasst den Verbindungs-Grundkörper 31 der jeweiligen Justage-Verbindungselemente 30 teilweise.

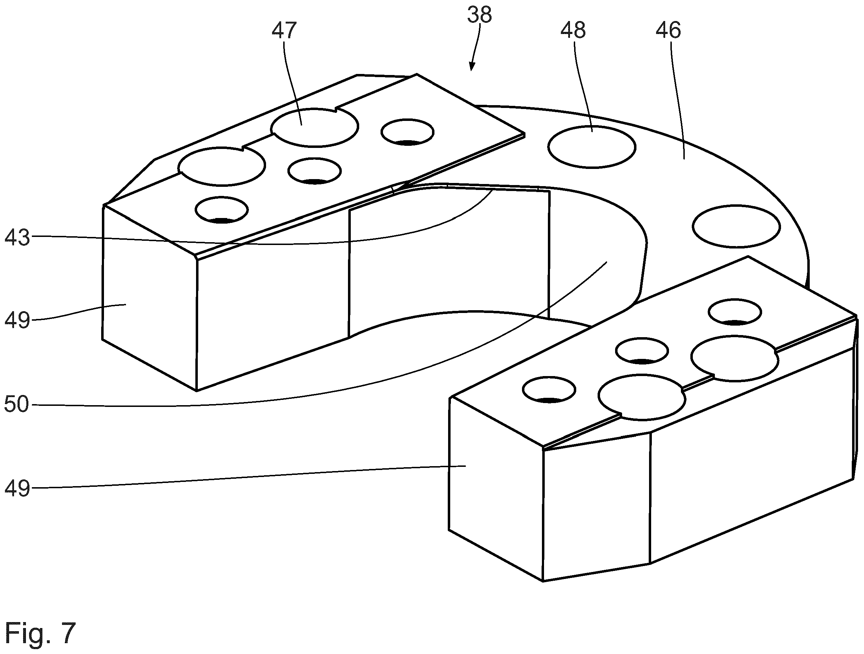

Die Lager-Komponente 38 wird nachfolgend unter Bezugnahme auf die Fig. 7 näher erläutert.

Zur Befestigung des jeweiligen Tragrahmen-Flansches 33 in der Aufnahme 36 des Tragrahmens 35 dienen Tragrahmen-Befestigungselemente 39. Der jeweilige Tragrahmen-Flansch 33 umfasst dabei sechs Durchgangsöffnungen, über die die Tragrahmen-Befestigungselemente 39 den jeweiligen Tragrahmen-Flansch 33 kraftschlüssig in der Aufnahme 36 des Tragrahmens 35 befestigen. Im in der Fig. 3 gezeigten Ausführungsbeispiel dienen die Tragrahmen-Befestigungselemente 39 zur kraftschlüssigen Verbindung der jeweiligen Tragrahmen-Flansche 33 mit der jeweiligen Lager-Komponente 38. Die jeweiligen Lager-Komponenten 38 sind in ihren jeweiligen Aufnahmen 36 insbesondere derart befestigt, dass die Lager-Komponente 38 die Form des V-förmigen Lagers der Aufnahme 36 des Tragrahmens 35 erhalten. Das V-förmige Lager wird dann also von der Aufnahme 36 des Tragrahmens 35 und der Lager-Komponente 38 ausgebildet. Auch in diesem Fall ist das jeweilige Justage-Verbindungselement 30 zentriert in dem V-förmigen Lager angeordnet.

Weiterhin sind in der Fig. 3 die Justage-Verbindungselemente 30 jeweils mit mindestens einem Justage-Distanzelement 40 dargestellt. Die Justage-Distanzelemente 40 sind dabei als Distanzscheiben ausgebildet, die zwischen dem jeweiligen Tragrahmen-Flansch 33 und der jeweiligen Lager-Komponente 38 angeordnet sind. Die Justage-Distanzelemente 40 sind dabei ebenfalls hufeisenförmig ausgebildet. Über die Justage-Distanzelemente 40 lässt sich die Länge der Justage-Verbindungselemente 30 vergrößern oder verringern. Im in der Fig. 3 gezeigten Ausführungsbeispiel ist jedes der Justage-Verbindungselemente 30 mit genau zwei Justage-Distanzelementen 40 dargestellt. Es ist jedoch auch möglich, dass einzelne Justage-Verbindungselemente 30 mehr als zwei Justage-Distanzelemente 40 oder weniger als zwei, insbesondere kein Justage-Distanzelement 40 aufweisen.

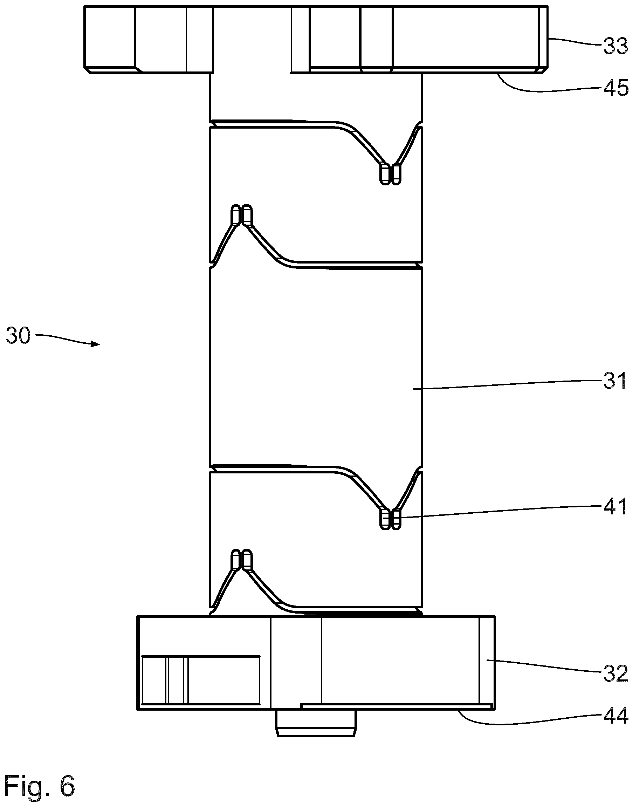

Die Justage-Verbindungselemente 30 umfassen mindestens ein Festkörper-Gelenk 41. Im in der Fig. 3 gezeigten Ausführungsbeispiel umfasst jedes der Justage-Verbindungselemente 30 genau vier Festkörper-Gelenke 41, die unter Bezugnahme auf Fig. 6 später näher erläutert werden.

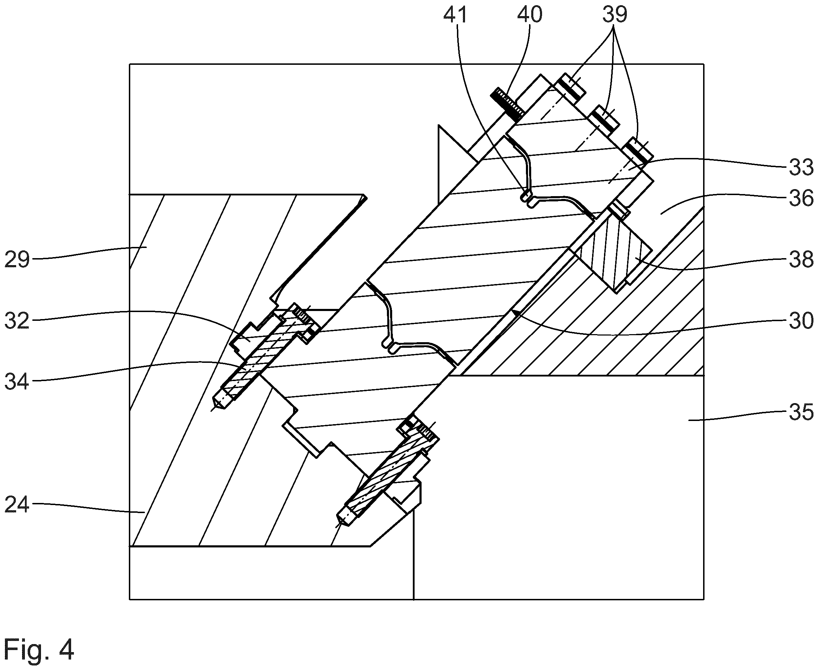

Fig. 4 zeigt eine Schnittdarstellung der durch das Justage-Verbindungselement 30 hergestellten, hängenden Lagerung des Spiegels 24 am Tragrahmen 35. Das Justage-Verbindungselement 30 ist dabei in dem, durch die Lager-Komponente 38 ausgebildeten, V-Lager zentriert angeordnet. Es entsteht insbesondere kein Zwischenraum zwischen dem Tragrahmen-Flansch 33 und der Lager-Komponente 38. Es entsteht weiterhin auch kein Zwischenraum zwischen dem Justage-Verbindungselement 30 und der Aufnahme 36 des Tragrahmens 35.

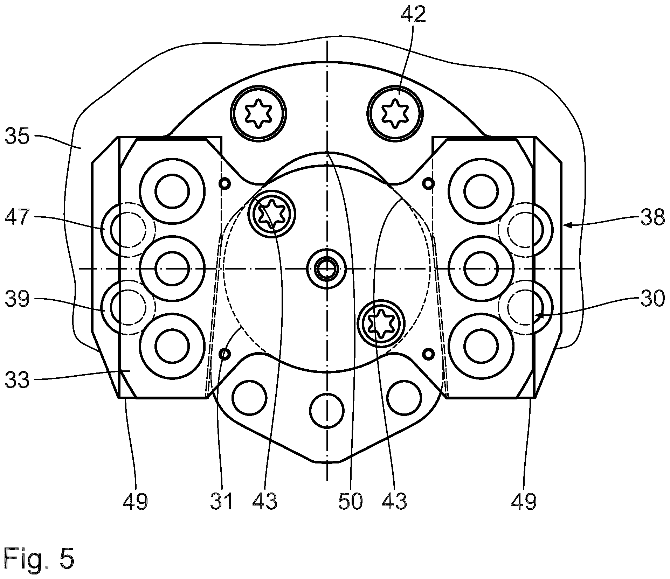

Fig. 5 zeigt die Befestigung des Tragrahmen-Flansches 33 an der Lager-Komponente 38. Das Justage-Verbindungselement 30 ist über den Tragrahmen-Flansch 33 an der Lager-Komponente 38 kraftschlüssig angebracht. Hierzu dienen die Tragkörper-Befestigungselemente 39, welche durch die Durchgangsöffnungen des Tragrahmen-Flansches 33 verlaufen und den Tragrahmen-Flansch 33 dadurch an der Lager-Komponente 38 anbringen.

Die Lager-Komponente ist über Schrauben 42 am Tragrahmen 35 montiert.

Das Justage-Verbindungselement 31 ist in dem durch die Lager-Komponente 38 ausgebildeten V-förmigen Lager zentriert angeordnet. Hierbei liegt das Justage-Verbindungselement 31 nur an zwei Auflagepunkten 43 auf der Befestigungs-Komponente auf. Abgesehen von dieser Kontaktierung berührt das Justage-Verbindungselement 30 die Lager-Komponente 38 nicht.

Im in der Fig. 5 gezeigten Ausführungsbeispiel sind die Auflagepunkte 43 als Linienkontakte ausgebildet. Die Linienkontakte haben dabei eine Länge von wenigen Millimetern, insbesondere von höchstens 5 mm, von höchstens 2 mm, von höchstens 1 mm und insbesondere von höchstens 0,5 mm. Es ist auch möglich, dass das Justage-Verbindungselement 30 die Lager-Komponente 38 nur über einen Punktkontakt kontaktiert. Die Länge des jeweiligen Linienkontakts ist regelmäßig größer als 0,1 mm.

Fig. 6 zeigt ein Justage-Verbindungselement 30 in vergrößerter Ansicht. Das Justage-Verbindungselement 30 hat einen stabförmig ausgebildeten Verbindungs-Grundkörper 31. An den Enden des stabförmig ausgebildeten Verbindungs-Grundkörpers 31 ist jeweils ein Flansch 32, 33 in Form eines Spiegel-Flansches 32 und eines Tragrahmen-Flansches 33 angeordnet. Die jeweiligen Flansche 32, 33 verlaufen senkrecht zur Mittelachse des stabförmig ausgebildeten Verbindungs-Grundkörpers 31. Weiterhin ist der Spiegel-Flansch 32 senkrecht zum Tragrahmen-Flansch 33 ausgebildet. Der Tragrahmen-Flansch 33 weist eine größere Ausdehnung auf als der Spiegel-Flansch 32.

Der Spiegel-Flansch 32 weist eine Spiegel-Auflagefläche 44 auf. Mit der Spiegel-Auflagefläche 44 kontaktiert das Justage-Verbindungselement 30 den Spiegel 24, insbesondere die Spiegel-Aufnahme 29 des Spiegel-Aufhängkörpers 27.

Der Tragrahmen-Flansch 33 weist eine Tragrahmen-Auflagefläche 45 auf mit der das Justage-Verbindungselement 30 die Lager-Komponente 38 in der Aufnahme 36 des Tragrahmens 35 kontaktiert.

Der Verbindungs-Grundkörper 31 umfasst vier Festkörper-Gelenke 41. Die Festkörper-Gelenke 41 sind als Aussparungen im Verbindungs-Grundkörper 31 ausgebildet. Diese Festkörper-Gelenke 41 können direkt bei der Produktion des Justage-Verbindungselements 30 in den Verbindungs-Grundkörper 31 eingebracht werden. Es ist auch möglich, die Festkörper-Gelenke 41 nachträglich in den Verbindungs-Grundkörper einzubringen, beispielsweise einzuschneiden oder einzufräsen.

Durch die Festkörper-Gelenke 41 erhält der Verbindungs-Grundkörper 31 elastische Eigenschaften. Der Verbindungs-Grundkörper 31 kann insbesondere bei jedem der vier Festkörpergelenke um eine Rotationsachse verkippt werden. Durch die Ausbildung des Verbindungs-Grundkörpers 31 mit vier Festkörper-Gelenken 41 kann das Justage-Verbindungselement 30 um zwei Rotationsfreiheitsgrade verkippt werden. Durch das Zusammenspiel von mindestens zwei unterschiedlichen Festkörper-Gelenken 41 kann das Justage-Verbindungselement 30 auch entlang der drei Translationsfreiheitsgrade bewegt werden.

Insbesondere durch die Verwendung von sechs Justage-Verbindungselementen 30 ist es dadurch möglich, den Spiegel 24 vollständig um alle sechs Freiheitsgrade, also um drei Freiheitsgrade der Rotation und um drei Freiheitsgrade der Translation, justierbar an dem Tragrahmen 35 hängend zu lagern. Es ist also insbesondere möglich, den Spiegel 24, insbesondere die Reflexionsfläche 28 entlang dreier Rotationsfreiheitsgrade zu verdrehen und/oder dreier Translationsfreiheitsgrade zu bewegen.

Ein elastisch ausgebildetes Justage-Verbindungselement 30 ermöglicht darüber hinaus auch ein erleichtertes Anbringen des Spiegels 24 an dem Tragrahmen 35.

Beim Anbringen des Spiegels 24 am Tragrahmen 35 werden nicht automatisch alle sechs Justage-Verbindungselemente 30 in zentrierter Position in den Aufnahmen 36 bzw. in den, durch die Lager-Komponente 38 und/oder die Aufnahmen 36 ausgebildeten, V-förmigen Lager zentriert angeordnet. Vielmehr wird zunächst ein Justage-Verbindungselement 30 in einem zugehörigen V-Lager angeordnet. Durch die Gravitation wird dieses Justage-Verbindungselement 30 sich selbstständig in dem V-Lager zentrieren.

Hierbei werden das Einbringen und das Zentrieren bereits von der Elastizität des Justage-Verbindungselements 30 unterstützt.

Sukzessive werden sodann die weiteren Justage-Verbindungselemente 30 in ihre jeweiligen V-förmigen Lager eingebracht und durch die Gravitation selbstständig zentriert. Hierbei wird die vorstehend genutzte Elastizität der Verbindungs-Grundkörper 31 der Justage-Verbindungselemente 30 genutzt.

Fig. 7 zeigt eine Lager-Komponente 38 in vergrößerter Darstellung. Die Lager-Komponente 38 weist einen hufeisenförmigen Querschnitt auf.

Die Lager-Komponente 38 weist eine Kontakt-Fläche 46 auf. Mit der Kontakt-Fläche 46 kontaktiert die Lager-Komponente 38 die Tragrahmen-Auflagefläche 45 des Justage-Verbindungselements 30.

Die Lager-Komponente 38 weist weiterhin eine Mehrzahl von Durchgangsöffnungen 47, 48 auf. Mittels der Durchgangsöffnungen 47 wird die Lager-Komponente an dem Justage-Verbindungselement 30 befestigt. Die Durchgangsöffnungen 48 dienen dazu, die Lager-Komponente 38 in der Aufnahme 36 des Tragrahmens 35 zu befestigen.

Die Lager-Komponente 38 weist zwei parallel zueinander verlaufende Schenkel 49 auf. Die Durchgangsöffnungen 47 sind im Bereich dieser Schenkel 49 angeordnet.

Die Lager-Komponente weist einen Scheitel 50 auf, der zwischen den Schenkeln 49 liegt. Die Durchgangsöffnungen 48 sind im Bereich des Scheitels 50 angeordnet.

Durch das Zusammenspiel der Schenkel 49 und des Scheitels 50 bildet die Lager-Komponente 38 ihren hufeisenförmigen Querschnitt aus. Hierdurch bildet die Lager-Komponente 38 das V-förmige Lager.

Weiter ist in der Fig. 7 einer der zwei Auflagepunkte 43 dargestellt, an welchem die Lager-Komponente 38 den Verbindungs-Grundkörper 31 des Justage-Verbindungselements 30 kontaktiert.

Zum hängenden Lagern der optischen Komponente in Form des Spiegels 24 am Tragrahmen 35 wird nach Bereitstellen der optischen Komponente mindestens eines der Justage-Verbindungselemente, im beschriebenen Beispiel der sechs Justage-Verbindungselemente 30, und des Tragrahmens das jeweilige Justage-Verbindungselement 30 am Komponenten-Grundkörper 25 angebracht und das Justage-Verbindungselement 30 mit hieran angebrachtem Komponenten-Grundkörper in die mindestens eine Aufnahme eingebracht. Dies geschieht so, dass sich das Justage-Verbindungselement 30 in der Aufnahme aufgrund der Gravitationswirkung der optischen Komponente, also des Spiegels 24 in den vorstehend beschriebenen Lagern mit den Lager-Komponenten 38 zentriert.

## Patentansprüche

1. Baugruppe für eine optische Komponente (24, 30, 35), umfassend
- eine optische Komponente (24) mit einem Komponenten-Grundkörper (25) und einer optischen Fläche (28),
- mindestens ein Justage-Verbindungselement (30),
- einen Tragrahmen (35) mit mindestens einer Aufnahme (36),
- wobei das mindestens eine Justage-Verbindungselement (30) am Komponenten-Grundkörper (25) angebracht ist, und
- wobei der Komponenten-Grundkörper (25) über das mindestens eine Justage-Verbindungselement (30) justierbar an dem Tragrahmen (35) hängend gelagert ist, wobei das Justage-Verbindungselement (30) in die mindestens eine Aufnahme (36) des Tragrahmens (35) eingreift.

2. Baugruppe (24, 30, 35) gemäß Anspruch 1, **gekennzeichnet durch** eine Lager-Einrichtung (37), die zwischen dem Justage-Verbindungselement (30) und der Aufnahme (36) angeordnet ist.

3. Baugruppe (24, 30, 35) gemäß Anspruch 2, **dadurch gekennzeichnet, dass** die Lager-Einrichtung (37) eine Lager-Komponente (38) mit einem Querschnitt aufweist, der nach einer Seite hin offen gestaltet ist.

4. Baugruppe (24, 30, 35) gemäß Anspruch 3, **dadurch gekennzeichnet, dass** das Justage-Verbindungselement (30) die Lager-Komponente (38) an höchstens zwei Auflagepunkten (43) kontaktiert.

5. Baugruppe (24, 30, 35) gemäß einem der vorhergehenden Ansprüche, **gekennzeichnet durch** mindestens drei Justage-Verbindungselemente (30).

6. Baugruppe (24, 30, 35) gemäß Anspruch 5, **dadurch gekennzeichnet, dass** jedes der mindestens zwei Justage-Verbindungselemente (30) mit einer Zugkraft belastet wird, wobei die Zugkraft größer ist als 0 N.

7. Baugruppe (24, 30, 35) gemäß einem der vorhergehenden Ansprüche, **dadurch gekennzeichnet, dass** das Justage-Verbindungselement (30) einen stabförmigen Verbindungs-Grundkörper (31) aufweist.

8. Baugruppe (24, 30, 35) gemäß Anspruch 7, **dadurch gekennzeichnet, dass** der Verbindungs-Grundkörper mindestens ein Festkörper-Gelenk (41) aufweist.

9. Baugruppe (24, 30, 35) gemäß einem der vorgehenden Ansprüche, **dadurch gekennzeichnet, dass** eine Ausdehnung des Justage-Verbindungselements (30) mittels eines Justage-Distanzelements (40) einstellbar ist.

10. Verfahren zum hängenden Lagern einer optischen Komponente (24) an einem Tragrahmen (35), umfassend die Schritte:
- Bereitstellen einer optischen Komponente (24) mit einem Komponenten-Grundkörper (25) und einer optischen Fläche (28),
- Bereitstellen mindestens eines Justage-Verbindungselements (30),
- Bereitstellen eines Tragrahmens (35) mit mindestens einer Aufnahme (36),
- Anbringen des mindestens einen Justage-Verbindungselements (30) am Komponenten-Grundkörper (25) und
- Einbringen des mindestens einen Justage-Verbindungselements (30) in die mindestens eine Aufnahme (36), sodass die optische Komponente (24) am Tragrahmen (35) hängt, wobei das Justage-Verbindungselement (30) so eingebracht wird, dass es sich in der Aufnahme (36) durch die Wirkung der Gravitation zentriert.

11. Beleuchtungsoptik (4) mit einer Baugruppe (24, 30, 35) gemäß einem der Ansprüche 1 bis 9.

12. Beleuchtungssystem (2) gemäß Anspruch 11 mit einer Beleuchtungsoptik gemäß Anspruch 11 und einer Lichtquelle (3) zur Erzeugung von Beleuchtungsstrahlung (16).

13. Optisches System mit einem Beleuchtungssystem (2) gemäß Anspruch (12).

14. Projektionsbelichtungsanlage (1) mit einem optischen System gemäß Anspruch 13.
